# EUROPEAN PATENT APPLICATION

(11) **EP 4 002 494 A1**
(43) Date of publication of application: **25.05.2022**
(21) Application number: 20207357.3
(22) Date of filing: 13.11.2020
(51) Int. Cl.: H01L 31/0749, H01L 31/0296, H01L 31/0336

(54) **OPTOELECTRONIC DEVICE**

(71) Applicant: AIT Austrian Institute of Technology GmbH, 1210 Wien (AT)
(72) Inventor: Dimopoulos, Theodoros, 3423 St. Andrä-Wördern (AT); Wibowo, Rachmat Adhi, 1130 Wien (AT); Abermann, Stephan, 1050 Wien (AT)
(74) Representative: Schwarz & Partner Patentanwälte GmbH

(57) **Abstract**

The present invention relates to an optoelectronic device (1), preferably a photovoltaic device, comprising:
a) a rear electrode (2),
b) a buffer layer (3) comprising an n-type zinc-oxysulfide or zinc-magnesium-oxide semiconductor,
c) a window layer (4) comprising n-type titanium oxide semiconductor, and
d) a front electrode (5).

## Description

### TECHNICAL FIELD

The present invention relates to the field of optoelectronic devices, in particular photovoltaic devices.

### BACKGROUND ART

Optoelectronic devices and in particular photovoltaic (PV) or photoelectrochemical (PEC) devices are well-known in the art. For example, PV devices based on copper-indium-gallium-selenide(CIGS), p-type, semiconductor photon absorption layer, have a particularly high power conversion efficiency, with record value surpassing 23%.

The fabrication of a CIGS PV device is described as follows:
(i) A rigid or flexible substrate (e.g. glass, polyimide foil or insulated steel foil) is coated with a layer of molybdenum (Mo), which serves as a rear electrode. The Mo layer is deposited by sputtering.
(ii) On the Mo layer, the p-type CIGS photon absorption layer is deposited, predominantly by sputtering and/or evaporation, at temperatures 400-550°C. The CIGS photon absorption layer is a p-type semiconductor.
(iii) On the CIGS photon absorption layer, the n-type "buffer" layer is deposited. The buffer layer is in most cases cadmium sulfide (CdS), deposited by the chemical bath deposition (CBD) technique. The p-n heterojunction is therefore formed between the p-type CIGS and the n-type CdS.
(iv) After the CdS layer, the sample is transferred into the vacuum chamber for the sputtering of an n-type, undoped zinc oxide (ZnO) "window" layer. This layer serves to reduce the possibility of electrical shunts at the p-n heterojunction.
(v) Finally, a transparent front electrode is sputter-deposited on top of the ZnO layer. The transparent front electrode consists of n-type, aluminum-doped ZnO (AZO) or indium-tin-oxide (ITO), with low sheet resistance.

Several problems can be identified in the described fabrication approach and device performance. These are:
(i) The use of cadmium - a highly toxic material - in the fabrication of the buffer layer.
(ii) The use of a chemical process (chemical bath deposition) for the fabrication of the cadmium-based buffer, which leads to toxic waste management problems and related costs.
(iii) Limitations in production throughput, related to the use of different processing techniques for the different device layers (i.e. vacuum-based techniques mixed with wet chemical techniques).
(iv) The low shunt resistance that may occur at the p-n heterojunction due to the presence of defects/contaminants.
(v) Unfavourable energy-band alignment between the photon absorption layer and the buffer/window layers, leading to increased charge carrier recombination.

To address the problem of Cd toxicity, the CdS buffer is sometimes replaced by a Cd-free, zinc oxysulfide (ZnOS), or zinc-magnesium-oxide (ZnMgO) buffer layer, both of which are n-type. The chemical bath deposited ZnOS buffer layer can be combined with a ZnMgO window layer, fabricated by atomic layer deposition (ALD), giving rise to a record efficiency CIGS solar cell. A CdS buffer layer can be combined with a titanium oxide (TiO₂) window layer, grown by ALD. It was demonstrated that the use of TiO₂ instead of ZnO increases the shunt resistance of the device, leading to increased power conversion efficiency.

The existing approaches in the art have only addressed individual problems from the list above, but no approach has been reported that addresses all problems at once.

It is an object of the present invention to provide an optoelectronic device, preferably a photovoltaic or photoelectrochemical device, which can be produced efficiently without using highly toxic metals like cadmium, avoiding chemical bath deposition steps and reducing the number of different layer deposition techniques. In addition thereto, the device should have an increased shunt resistant and a suitable energy-band alignment between the layers.

### SUMMARY OF THE INVENTION

Thus, the present invention relates to an optoelectronic device, preferably a photovoltaic device, comprising:
a) a rear electrode,
b) a buffer layer comprising an n-type zinc-oxysulfide or zinc-magnesium-oxide semiconductor, and
c) a window layer comprising n-type titanium oxide semiconductor.

In addition, the present invention relates to a photoelectrochemical device that comprises the above given optoelectronic device, wherein the optoelectronic device is a photovoltaic device that constitutes one of the electrodes, preferably the cathode, of the photoelectrochemical device, used for photoelectrolysis.

The term "photovoltaic device", as used herein, comprises any device that enables to separate photogenerated charge carriers in a photon absorption layer by the electric field of a p-n junction, thus converting light into electrical current.

According to a preferred embodiment of the present invention the device of the present invention comprises a front electrode.

It turned surprisingly out that a sputtered buffer layer comprising or consisting of an n-type zinc-oxysulfide or zinc-magnesium-oxide semiconductor can be combined with a likewise sputtered window layer comprising or consisting of a doped or undoped n-type titanium oxide semiconductor, thus achieving a Cd-free buffer/window bilayer and simultaneously a thoroughly sputtered one, which can be deposited at high throughput. The combination of n-type zinc-oxysulfide semiconductor layer and n-type titanium oxide semiconductor layer forming a bilayer, provides a suitable energy-band alignment with the CIGS photon absorption layer and a high shunt resistance, giving rise to high power conversion efficiency for the photovoltaic device. This buffer/window layer combination is particularly advantageous because it allows for the first time to use a vacuum-processing line to deposit continuously the whole device, preferably a photovoltaic or photoelectrochemical device, from bottom to top layer (i.e. rear electrode, photon absorption layer, buffer layer, window layer and optional front electrode), without vacuum breaks. This accelerates the production throughput and avoids contamination of the layers by being exposed to ambient conditions.

Instead of the ZnOS buffer, a zinc-magnesium oxide (ZnMgO) buffer layer could be used, in combination with the titanium-oxide window layer.

A further aspect of the present invention relates to a method of producing a device of the present invention, wherein buffer layer, window layer and optional front electrode are deposited by sputtering.

A method of producing an optoelectronic device according to the present invention, preferably a photovoltaic device, includes the fabrication of the buffer/window bilayer entirely by sputtering. Sputtering may also be used for the deposition of the optional front transparent electrode, which may include AZO or ITO. This means that all layers above the substructure (zinc-oxysulfide or zinc-magnesium-oxide, undoped or doped titanium oxide and optional front electrode) may be deposited by sputtering, without requiring vacuum breaks between the depositions of each of the layers.

### BRIEF DESCRIPTION OF THE FIGURES

FIG. 1 shows a schematic cross section view of an example photovoltaic device according to the present invention.
FIG. 2 shows a schematic cross section view of an alternative example photovoltaic device according to the present invention.
FIG. 3 shows optical transmittance and reflectance spectra of a sputtered, 100 nm thick ZnOS layer with 43/57 sulfur/oxygen atomic ratio, and of a sputtered, 40 nm thick niobium-doped titanium oxide (NTO) layer with 9/91 niobium/titanium atomic ratio. Also shown are Tauc plots for the extraction of the indirect and direct bandgap of the ZnOS and NTO layers.
FIG. 4 shows a schematic of the energy band alignment of the CIGS/ZnOS/NTO heterojunction, together with a simulated current density-voltage curve of a solar cell under AM1.5G illumination.
FIG. 5 shows X-Ray diffractograms of the ZnOS and NTO layers.
FIG. 6 shows cross section SEM images of a Mo/CIGS/ZnOS/NTO/Ag/AZO solar cell, deposited entirely by vacuum processing on a flexible, insulated steel substrate.
FIG. 7 (top) shows a diagram of dark and illuminated (AM1.5G) current density versus voltage curves for Mo/CIGS/ZnOS/NTO/Ag/AZO and Mo/CIGS/CdS/ZnO/Ag/AZO solar cells on the flexible, insulated steel substrate. FIG. 7 (below) shows a diagram of dark and illuminated (AM1.5G) current density versus voltage curves for Mo/CIGS/ZnOS/NTO/Ag/AZO and Mo/CIGS/ZnOS/ZnO/Ag/AZO solar cells on the flexible, insulated steel substrate.

### DESCRIPTION OF EMBODIMENTS

Photovoltaic devices, as particularly preferred optoelectronic devices, convert light into electricity utilizing the photovoltaic effect. A photovoltaic device is based on a p-n junction, made from a p-type semiconductor in contact with an n-type semiconductor. The principle of operation of a photovoltaic device is as follows. Light impinges on the device and it is absorbed in the semiconducting photon absorption layer (which is usually the p-type semiconductor). The absorbed light generates electron-hole pairs. The electrons are separated from the holes by the electric field across the p-n junction and are driven to the positive and negative terminals of the device (electrodes). If an external load is connected between the two terminals, then electrical current flows through the load.

Thin film photovoltaic devices incorporate thin film p-n heterojunctions, meaning that the p- and the n-type counterparts of the junction are not made from the same compound semiconductor. An example is photovoltaic devices based on the p-type CIGS photon absorption layer. The photon absorption layer thickness is typically ∼2 µm. In this case, the n-type layer (the buffer layer) is usually CdS. The n-type layer, with a typical thickness of 20-50 nm, is not arbitrarily chosen but it has to have a suitable energy band structure that matches the one of the photon absorption layer, so as to induce a low charge carrier recombination at the junction. To this respect, it is advantageous that the conduction band of the buffer layer positions higher by 0-0.4 eV with respect to the conduction band of the photon absorption layer (potential spike). The CdS buffer is not only used in combination with the CIGS photon absorption layer, but it is also widely used in combination with the CZTS (copper-zinc-tin-selenide), as well as the CdTe (cadmium telluride) photon absorption layers. Highly-efficient photon absorption layers are very often fabricated by vacuum-based techniques, including sputtering and evaporation. On the contrary, CdS is deposited by chemical bath deposition. This means that after the deposition of the photon absorption layer the vacuum should be broken in order for the CdS deposition to take place. Further, the CdS deposition generates toxic waste that has to be disposed, which creates additional costs, besides the health risk involved for the production personnel. After the deposition of the CdS, the processing continues under vacuum, with the deposition of the window layer and the transparent front electrode.

In order to produce Cd-free buffer layers, ZnOS was found to have a high potential when combined with a CIGS or CZTS photon absorption layer. By modifying the S/O atomic ratio, the bandgap, electron affinity and ionization potential of the ZnOS layer can be modified, which makes it possible to match photon absorption layers of different stoichiometries (and consequently different energy band positions). More specifically, it is known that the energy bandgap of CIGS increases with the Ga content, with a corresponding decrease of the electron affinity. On the other hand, the ZnOS bandgap presents a minimum when the S/O ratio is nearly 50/50, underscoring a pronounced dependence of the conduction and valence band edges on the S/O ratio. ZnOS layers can be fabricated by wet chemical techniques or vacuum-based techniques, like sputtering.

Likewise, ZnMgO could also serve as a buffer, where the modification of the band structure of the material is achieved by the adjustment of the Mg/Zn atomic ratio. The bandgap namely increases with the Mg content, with a concomitant decrease of the electron affinity. For Mg/Zn ratios above ∼30/70, structural modifications take place that compromise the functionality of the material as buffer layer. Also, for Mg/Zn ratio higher than 20/80, increased amount of defect states in the bandgap of the material increase the recombination rate. Both effects compromise the functionality of the material as a buffer. For this, it is preferred that the Mg/Zn ratio is not higher than 20/80.

The buffer layer is combined with a window layer, which serves to improve the quality of the heterojunction, mainly by reducing the possibility of electrical shunts. Photovoltaic devices without window layer have a lower shunt resistance, leading to a decreased power conversion efficiency. As window layer, undoped ZnO, fabricated by sputtering, is typically used in the art, with a typical thickness of 50 nm. ZnO window layers have been combined with CdS, as well as ZnOS buffer layers. The window layer is required to have an appropriate energy band alignment with the buffer layer, so that to keep the charge carrier recombination low at the buffer/window layer interface.

Recently it was shown that an ALD-grown TiO₂ window layer outperforms the ZnO window layer when combined with the CdS buffer and a CIGS photon absorption layer photovoltaic device. The photovoltaic device incorporating the CdS/TiO₂ bilayer showed higher performance than a photovoltaic device incorporating the CdS/ZnO bilayer. These reported photovoltaic devices, however, still incorporate the toxic, chemical bath-deposited CdS buffer. Furthermore, the ALD method, used to grow the TiO₂ layer, is different than the one used to deposit the photon absorption layer or the front transparent electrode of the device.

It was surprisingly found that a combination of the Cd-free ZnOS buffer layer with a titanium oxide, preferably an undoped or niobium-doped titanium oxide (NTO) window layer, shows the same or even a higher performance compared to a photovoltaic device comprising CdS buffer layer, as described above.

Additionally, a transparent front electrode can be achieved by sputtering on top of the NTO layer an ultra-thin (e.g. 5-15 nm) metal layer of preferably silver (Ag) or copper (Cu), preferably followed by a second dielectric layer, such as NTO, ITO or AZO. This transparent front electrode is advantageous compared to the commonly used AZO or ITO electrodes, especially for solar cells on flexible substrates (like steel foil). The advantages are: (i) the introduced ultra-thin metal-based transparent electrode has a much better mechanical stability upon bending compared to the state-of-the-art AZO or ITO, (ii) it does not need elevated deposition temperatures, (iii) high optical transmittance and low sheet resistance can be achieved through the adjustment of the metal layer thickness and the thickness of the dielectric layer.

According to a preferred embodiment of the present invention said device comprises a photon absorption layer between the rear electrode and the buffer layer.

According to a further embodiment of the present invention the rear electrode comprises or consists of molybdenum.

According to a further embodiment of the present invention the rear electrode is transparent and comprises or consists of a transparent conductive oxide, including, but not limited to AZO, ITO or fluorine-doped tin oxide (FTO).

The rear electrode could also consist of the substrate itself, if the substrate is electrically conductive, such as the steel substrate.

According to another preferred embodiment of the present invention the photon absorption layer comprises a p-type metal-chalcogenide semiconductor, including, but not limited to, CIGS and CZTS.

According to a further embodiment of the present invention the photon absorption layer comprises a p-type oxide semiconductor, including, but not limited to, Cu₂O (cuprous oxide) and CuO (cupric oxide).

According to a further preferred embodiment of the present invention the buffer layer comprises or consists of zinc-oxysulfide, wherein the sulfur/oxygen atomic ratio in the buffer layer ranges from 5/95 to 95/5, preferably from 10/90 to 50/50.

The use of zinc-oxysulfide (ZnOS) is particularly advantageous because it is non-toxic. By adjusting the S/O ratio within the layer the electronic properties of ZnOS can be adjusted to match the electronic properties of photon absorption layers with different compositions.

According to a preferred embodiment of the present invention the buffer layer comprises or consists of zinc-magnesium-oxide, wherein the zinc magnesium oxide buffer layer has a Mg/Zn atomic ratio of 5/95 to 30/70, preferably of 5/95 to 20/80. For Mg/Zn ratio higher than 30/70, structural changes in the material take place. Also, for Mg/Zn ratio higher than 20/80, increased amount of defect states in the bandgap of the material increase the recombination rate. Both effects compromise the functionality of the material as a buffer. For this, it is preferred that the Mg/Zn ratio is not higher than 20/80.

Also, zinc-magnesium-oxide (ZnMgO) is a non-toxic material like zinc-oxysulfide. The ratio Mg/Zn within the layer can be adjusted to match the electronic properties of photon absorption layers with different compositions.

According to a further preferred embodiment of the present invention the buffer layer has a thickness of 10 nm to 100 nm, preferably of 20 nm to 50 nm.

According to another preferred embodiment of the present invention the window layer comprises or consists of titanium oxide doped with niobium, molybdenum, tungsten, tantalum, vanadium and/or with another metal with oxidation state higher than +4.

The use of doped titanium oxide instead of undoped titanium oxide has several advantages. It allows faster sputter deposition, decreases the series resistance and decreases the width of the buffer/window interface potential barrier. Indeed, sputter targets of doped titanium oxide have higher electrical conductivities, which allows the use of direct current (DC) sputter mode, thus achieving high deposition rates. Also, doped titanium oxide layers have higher electron concentrations, increasing their electrical conductivity and decreasing the width of the potential barrier that may form at the buffer/window interface. This facilitates the electron collection to the front electrode.

According to a further preferred embodiment of the present invention the dopant/titanium, preferably niobium/titanium, atomic ratio within the window layer ranges from 1/99 to 30/70, preferably from 5/95 to 20/80.

According to a preferred embodiment of the present invention the window layer has a thickness of 10 nm to 100 nm, preferably of 20 nm to 50 nm.

According to another preferred embodiment of the present invention the front electrode is omitted. In this case, the optoelectronic device, consisting of the rear electrode, photon absorption layer, buffer layer and window layer can serve as cathode in a photoelectrochemical cell for water electrolysis. Thus, the cathode of the optoelectronic device is a photovoltaic device, which converts light into electrical current that drives the electrochemical reaction. The cathode and the anode of the photoelectrochemical device are immersed into an electrolyte. At the cathode, the photogenerated charge carriers in the photon absorption layer are separated by the p-n junction electric field. The electrons are thus transferred to the titanium oxide window layer, where they are used for water reduction. On the other hand, the holes are transferred to the rear electrode and then to the anode of the PEC device (e.g. platinum wire) where the water oxidation takes place.

According to another preferred embodiment of the present invention the front electrode is transparent.

According to a further preferred embodiment of the present invention the front electrode comprises a transparent conductive oxide.

According to a preferred embodiment of the present invention the transparent conductive oxide comprises zinc oxide doped with aluminum, gallium and/or indium.

According to another preferred embodiment of the present invention the transparent conductive oxide comprises tin-doped indium oxide.

According to a further preferred embodiment of the present invention the front electrode comprises or consists of a metal layer positioned on the window layer and an oxide or oxysulfide layer positioned on the metal layer.

According to a preferred embodiment of the present invention the metal layer comprises or consists of silver, copper, gold and/or alloys therefrom.

Preferred alloys of these metals include CuₓAg₍₁₋ₓ₎, CuₓAu₍₁₋ₓ₎ and AgₓAu₍₁₋ₓ₎.

According to another preferred embodiment of the present invention the metal layer has a thickness of 5 nm to 15 nm, preferably of 7 nm to 12 nm.

A metal/oxide or metal/oxysulfide transparent electrode has the advantage of high conductivity, mechanical flexibility and does not require the application of elevated deposition temperatures.

According to a further preferred embodiment of the present invention the oxide or oxysulfide layer comprises or consists of zinc oxide, doped zinc oxide, zinc oxysulfide, doped titanium oxide or indium-tin-oxide.

Zinc oxide, doped zinc oxide and indium-tin-oxide (ITO) are commonly used materials in the production of photovoltaic cells.

Doped titanium oxide can be the same material as in the buffer layer. This is advantageous because it allows to use the same sputter targets for the buffer layer and for the front transparent electrode.

Alternatively, the device could comprise a photon emitting layer, wherein the device may be a light emitting device.

Alternatively, the device could comprise a photon sensing layer, wherein the device may be an optical sensor device.

Another aspect of the present invention relates to a method of producing a device according to the present invention, wherein buffer layer, window layer and front electrode are deposited by sputtering.

The optoelectronic device of the present invention, in particular the photovoltaic device of the present invention, can be produced using sputtering and evaporation, without vacuum breaks. Since all layers can be produced in a single vacuum line the costs for manufacturing these devices can be significantly reduced compared to conventional methods.

According to a preferred embodiment of the present invention the buffer layer, the window layer and the front electrode are deposited by sputtering from ceramic targets and without oxygen in the plasma (non-reactive sputtering).

The use of non-reactive sputtering simplifies the deposition, and renders it faster compared to reactive sputtering.

The front electrode consists of a sputtered or evaporated ultra-thin (preferably 5-15 nm) metal layer, preferably of silver (Ag) or copper (Cu), followed by a second sputtered layer of a dielectric, including NTO, AZO or ITO.

The present invention is further illustrated in the following figures, however, without being restricted thereto.

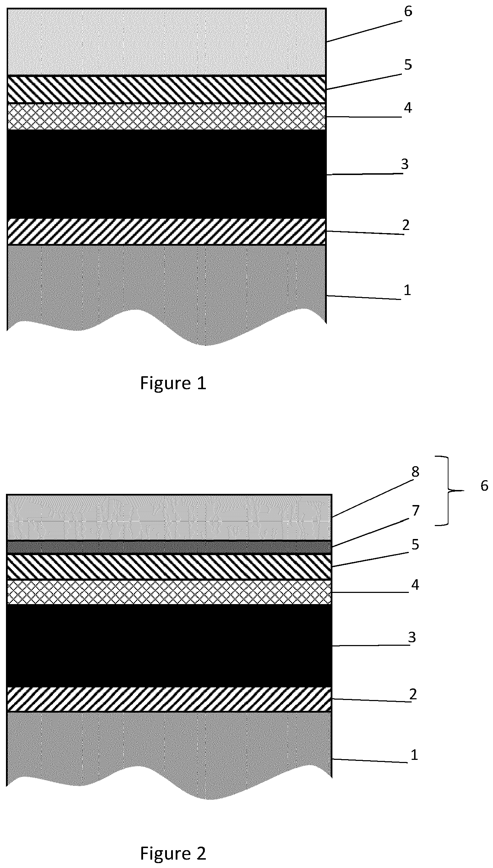

FIG. 1 shows a schematic cross section view of an example photovoltaic device according to an example embodiment of this invention. The photovoltaic device includes the substrate 1, which can be rigid glass or flexible steel or polyimide, the Mo rear electrode 2, the CIGS or CZTS photon absorption layer 3, the ZnOS or ZnMgO buffer layer 4, the TiOₓ (with x close to 2) or NTO window layer 5 and the transparent electrode 6, which can be a TCO, such as AZO or ITO. The S/O atomic ratio within the ZnOS buffer can be from 5/95 to 95/5. The Mg/Zn atomic ratio within the ZnMgO layer can be 5/95 to 30/70. The choice of the S/O or Mg/Zn ratio depends on the stoichiometry of the CIGS or the CZTS photon absorption layer. In general, it is advantageous that the stoichiometry of the ZnOS buffer is so chosen that a conduction band spike of less than 0.4 eV is induced at the photon absorption layer/buffer interface. The thickness of the buffer layer can be 10 to 100 nm, preferably between 20 and 50 nm. Although undoped TiO₂ may be used as window layer, the use of NTO (Nb/Ti between 2:98 and 20:80) has been shown advantageous in terms of: (a) Processing throughput. A Nb-doped TiOₓ sputter target can be used at direct current (DC) or radio frequency (RF) sputter mode to deposit films at high rates. (b) Increasing the carrier concentration of the material. This has an impact on the electric field distribution, facilitating the extraction of electrons towards the top electrode. (c) It reduces the series resistance of the solar cell. These effects contribute to the improvement of the efficiency of the solar cell. The thickness of the window layer may be between 10 and 100 nm, preferably between 20 and 50 nm.

FIG. 2 depicts another embodiment of the invention (Embodiment B), where the front transparent electrode 6 is composed of an ultra-thin metallic film 7 (thickness 5-15 nm), such as Ag or Cu, and a dielectric 8, such as NTO, AZO or ITO. The thickness of the dielectric 8 is chosen so that the light absorption in the photon absorption layer 3 is maximized. For the optimum dielectric layer 8 thickness, the reflected light beams at the different interfaces of the transparent electrode, window and buffer layers are destructively interfering, leading to a maximum light absorption in the photon absorption layer. The sheet resistance of the transparent electrode is mainly determined by the type and thickness of the metal layer.

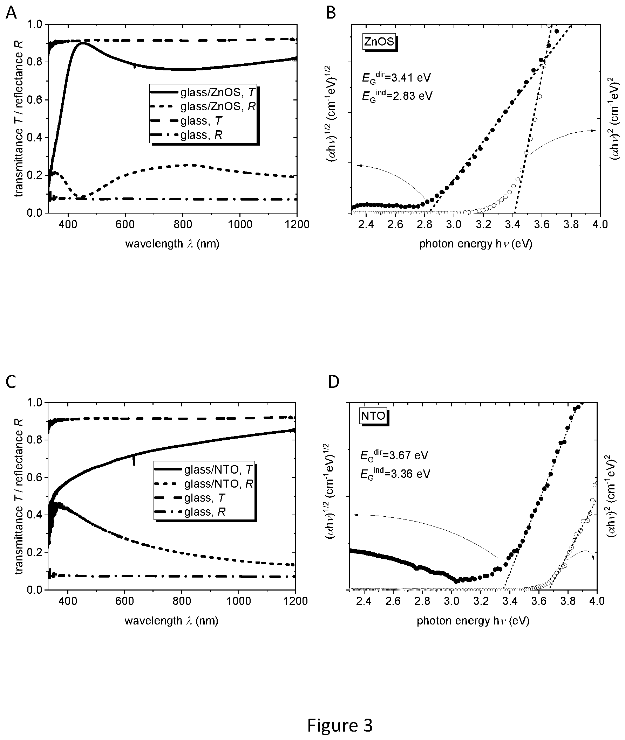

FIG. 3 shows optical transmittance and reflectance spectra of a 100 nm thick, sputtered ZnOS layer with S/O=43/57 (Fig. 3A), and of a 40 nm thick NTO layer with Nb/Ti=9/91 (Fig. 3C). The ZnOS layer has been deposited by RF magnetron sputtering in Ar atmosphere, from a ZnOS target. The NTO layer has been deposited by direct current (DC) magnetron sputtering from a Nb:TiOₓ target, also in Ar atmosphere. Both layers were sputtered without substrate heating. This does not limit the sputter deposition conditions that may be used, like for example sputtering in a reactive Ar/O₂ atmosphere. The layers have a high optical transmittance in the range 350-1100, which is necessary for their use as buffer and window layers.

FIG. 3 also shows the constructed Tauc plots for the extraction of the bandgap of the ZnOS (Fig. 3B) and NTO layers (Fig. 3D), assuming direct and indirect types of bandgap. An indirect type of bandgap is more probable for these layers. The indirect bandgap of ZnOS is 2.83 eV. The bandgap of ZnOS is higher than the bandgap of CdS (2.4 eV) which is an advantage, as it means that the ZnOS has a higher transmittance at low wavelengths. The indirect bandgap of NTO is 3.36 eV, which is also higher than the bandgap of the commonly used ZnO window layer (3.2 eV). Ultra-violet photoemission spectroscopy (UPS) measurements yielded an ionization potential of 6.67 eV for ZnOS and 6.92 eV for NTO. Taking into account the extracted bandgaps, one finds an electron affinity of 3.84 eV for ZnOS and 3.56 eV for NTO.

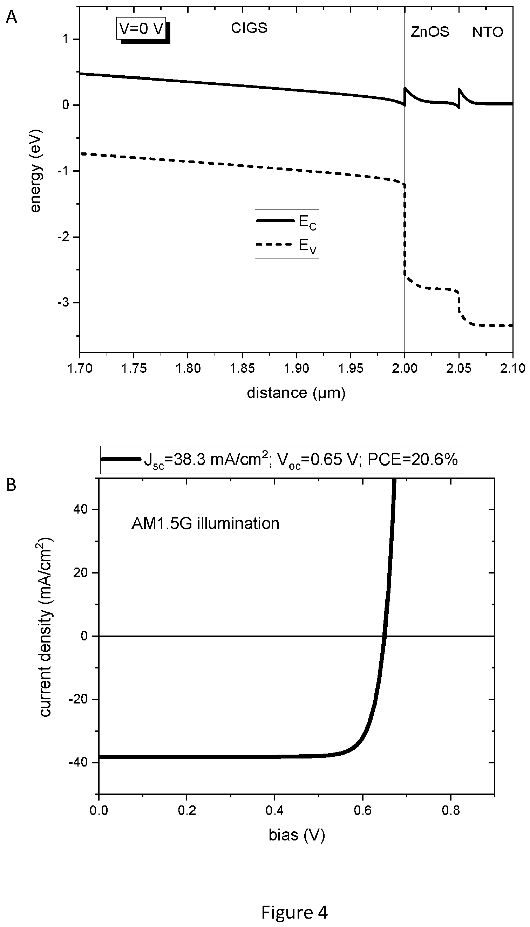

FIG. 4A presents a schematic of the energy band alignment at the CIGS/ZnOS/NTO heterojunction, taking into account that the CIGS photon absorption layer electron affinity is 4.1 eV and the bandgap 1.2 eV. A potential spike in the conduction band ∼250 meV appears at the CIGS/ZnOS interface. A potential spike in the conduction band also appears at the ZnOS/NTO interface of ∼200 meV. FIG. 4B depicts a simulated current density-voltage (J-V) curve under AM1.5G illumination, for the structure CIGS/ZnOS/NTO, corresponding to the band diagram of FIG. 4A. The simulated curve gives a short circuit current density J_{SC} of 38.3 mA/cm², an open circuit voltage V_{OC} of 0.65 V and a power conversion efficiency of 20.6%.

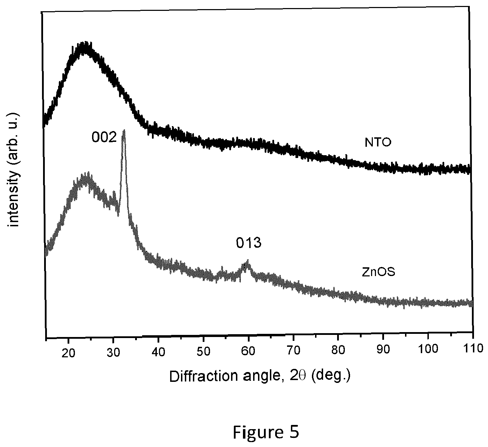

FIG. 5 illustrates X-Ray diffractograms of the ZnOS and NTO layers, deposited on glass substrate. The ZnOS layer is textured, with a dominant wurtzite (002) reflection and a less pronounced (013) reflection. The NTO layer is amorphous, as no reflection peak appears in the diffractogram (only the background signal from the glass substrate is present).

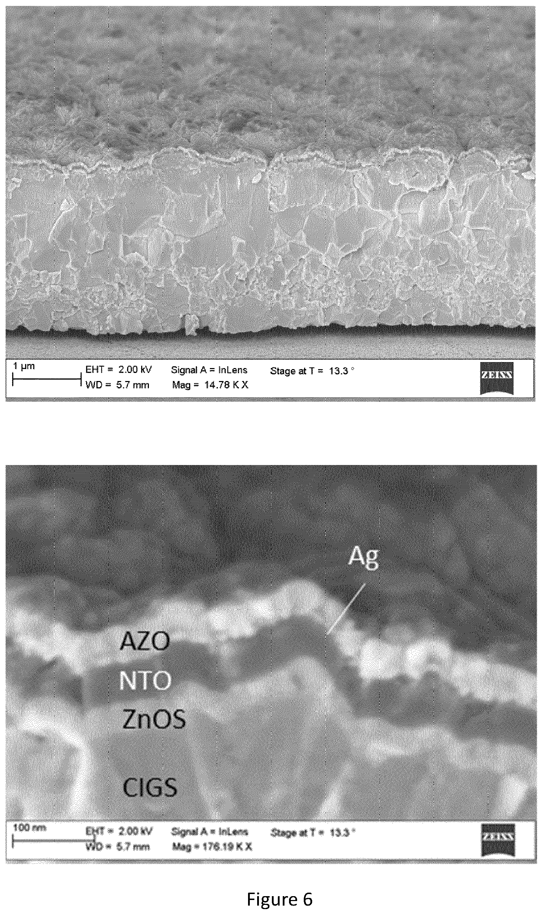

FIG. 6 depicts cross section SEM images of a Mo/CIGS/ZnOS/NTO/Ag/AZO solar cell, fabricated on a flexible steel substrate (covered with an insulating SiO₂ layer). All the layers in the solar cell were deposited by sputtering or a sputter/evaporation hybrid process (for the CIGS photon absorption layer). In the high magnification image one can distinguish the conformal and continuous layers of ZnOS, NTO, Ag and AZO, covering the CIGS photon absorption layer.

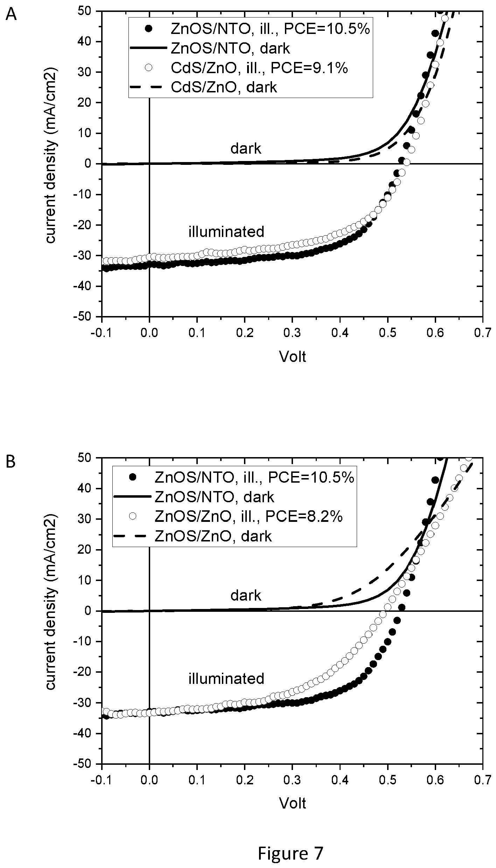

FIG. 7A illustrates dark and illuminated (AM1.5G) current density versus voltage curves for Mo/CIGS/ZnOS/NTO/Ag/AZO and Mo/CIGS/CdS/ZnO/Ag/AZO solar cells on the flexible, insulated steel substrate. FIG. 7B is a diagram of dark and illuminated (AM1.5G) current density versus voltage curves for Mo/CIGS/ZnOS/NTO/Ag/AZO and Mo/CIGS/ZnOS/ZnO/Ag/AZO solar cells on the flexible, insulated steel substrate. The solar cells with the ZnOS/NTO bilayer have a higher efficiency than the reference cells with the CdS/ZnO bilayer, or the cells with the ZnOS/ZnO bilayer.

## Claims

1. An optoelectronic device (1), preferably a photovoltaic device, comprising:
a) a rear electrode (2),
b) a buffer layer (3) comprising an n-type zinc-oxysulfide or zinc-magnesium-oxide semiconductor, and
c) a window layer (4) comprising n-type titanium oxide semiconductor.

2. The device of claim 1, wherein said device comprises further a front electrode (5).

3. The device of claim 1 or 2, wherein said device comprises a photon absorption layer (6) between the rear electrode (2) and the buffer layer (3).

4. The device of any one of claims 1 to 3, wherein the rear electrode (2) comprises molybdenum.

5. The device of claim 3 or 4, wherein the photon absorption layer (6) comprises a p-type metal-chalcogenide semiconductor.

6. The device of any one of claims 1 to 5, wherein the buffer layer (3) comprises or consists of zinc-oxysulfide, wherein the sulfur/oxygen atomic ratio in the buffer layer ranges from 5/95 to 95/5, preferably from 10/90 to 50/50.

7. The device of any one of claims 1 to 5, wherein the buffer layer (3) comprises or consists of zinc-magnesium-oxide, wherein the zinc magnesium oxide buffer layer has a magnesium/zinc atomic ratio of 5/95 to 30/70, preferably of 5/95 to 20/80.

8. The device of any one of claims 1 to 7, wherein the buffer layer (3) has a thickness of 10 nm to 100 nm, preferably of 20 nm to 50 nm.

9. The device of any one of claims 1 to 8, wherein the window layer (4) comprises or consists of titanium oxide doped with niobium, molybdenum, tungsten, tantalum, vanadium and/or with another metal with oxidation state higher than +4.

10. The device of any one of claim 1 to 9, wherein with dopant/titanium atomic ratio within the window layer (4) ranges from 1/99 to 30/70, preferably from 5/95 to 20/80.

11. The device of any one of claim 1 to 10, wherein the window layer (4) has a thickness of 10 nm to 100 nm, preferably of 20 nm to 50 nm.

12. The device of any one of claims 2 to 11, wherein the front electrode (5) is transparent, wherein the front transparent electrode (5) preferably comprises a transparent conductive oxide, wherein the transparent conductive oxide preferably comprises zinc oxide doped with aluminium, gallium and/or indium, and/or tin-doped indium oxide.

13. The device of any one of claim 1 to 12, wherein the front electrode (5) comprises or consists of a metal layer (7) positioned on the window layer (4) and an oxide or oxysulfide layer (8) positioned on the metal layer (7), wherein the metal layer (7) preferably comprises or consists of silver, copper, gold and/or alloys therefrom, wherein the metal layer (7) has preferably a thickness of 5 nm to 15 nm, preferably of 7 nm to 12 nm.

14. The device of claim 13, wherein the oxide or oxysulfide layer (8) comprises or consists of zinc oxide, doped zinc oxide, zinc oxysulfide, doped titanium oxide or indium-tin-oxide.

15. A method of producing a device of any one of claims 1 to 14, wherein a buffer layer (3), a window layer (4) and optionally a front electrode (5) are deposited by sputtering, preferably by sputtering from ceramic targets and without oxygen in the plasma.
